# EUROPÄISCHE PATENTSCHRIFT

(11) **EP 1 727 925 B1**
(45) Veröffentlichungstag und Bekanntmachung des Hinweises auf die Patenterteilung: **04.08.2010**
(21) Anmeldenummer: 05736348.3
(22) Anmeldetag: 22.03.2005
(51) Int. Cl.: C23C 16/34, C23C 16/452

(54) **VERFAHREN ZUR AUSBILDUNG DÜNNER SCHICHTEN AUS SILIZIUMNITRID AUF SUBSTRATOBERFLÄCHEN**
METHOD FOR FORMING THIN SILICON NITRIDE LAYERS ON THE SURFACE OF SUBSTRATES
PROCEDE POUR FORMER DE FINES COUCHES DE NITRURE DE SILICIUM SUR DES SURFACES SUPPORTS

(30) Priorität: 23.03.2004 DE 102004015217
(43) Veröffentlichungstag der Anmeldung: 06.12.2006
(73) Patentinhaber: Fraunhofer-Gesellschaft zur Förderung der angewandten Forschung e.V., 80686 München (DE)
(72) Erfinder: ROGLER, Daniela, 01277 Dresden (DE); HOPFE, Volkmar, 01814 Kleingiesshübel (DE); MÄDER, Gerrit, 01187 Dresden (DE)
(74) Vertreter: Pfenning, Meinig & Partner GbR
(86) Internationale Anmeldenummer: PCT/DE2005/000549
(87) Internationale Veröffentlichungsnummer: WO 2005/093125

(56) Entgegenhaltungen:
- EP-A- 1 394 283
- US-A- 5 014 646
- US-A- 5 393 563
- US-A- 5 578 130
- DATABASE INSPEC [Online] THE INSTITUTION OF ELECTRICAL ENGINEERS, STEVENAGE, GB; Februar 2002 (2002-02), NOWLING G R ET AL: "Remote plasma-enhanced chemical vapour deposition of silicon nitride at atmospheric pressure" XP002337126 Database accession no. 7259594 & G.R. NOWLING ET AL: Plasma Sources, Science and Technology IOP Publishing UK, Bd. 11, Nr. 1, Februar 2002 (2002-02), Seiten 97-103, uk ISSN: 0963-0252
- FAINER N I ET AL: "The investigation of properties of silicon nitride films obtained by RPECVD from hexamethyldisilazane" APPLIED SURFACE SCIENCE, Bd. 113-114, 1. Juli 1996 (1996-07-01), Seiten 614-617, XP002341095 NL

## Beschreibung

Die Erfindung betrifft ein Verfahren zur Ausbildung dünner Schichten aus Siliziumnitrid auf Substratoberflächen, wobei die Schichtausbildung aus der Gasphase bei dem jeweiligen Atmosphärendruck entsprechenden Bedingungen erfolgen soll. Dabei ist unter Atmosphärendruckbedingungen ein relativ kleines Druckintervall, um den jeweiligen normalen Atmosphärendruck zu verstehen, so dass eine klare Abgrenzung zu den an sich bekannten Beschichtungsverfahren, die unter die Gruppen CVD- und PVD-Verfahren in Vakuumkammern fallen, eingehalten wird.

Mit der erfindungsgemäßen Lösung können auf unterschiedlichsten Substratoberflächen auch transparente, so genannte "Kratzschutzschichten", Schichten mit antireflexierenden Eigenschaften auf optischen Elementen, wie Glasfenster oder Brillen, Isolations- bzw. Passivierungsschichten für mikroelektronische Elemente, Dichtungen für Membranen oder Ätzmasken in der Mikroelektronik sowie insbesondere Passivierungs- und antireflektierende Schichten auf Solarzellen hergestellt werden.

Die bereits erwähnten Verfahren zur Ausbildung von Schichten im Vakuum weisen mehrere Nachteile auf, so ist für die Druckreduzierung in den Vakuumkammern ein erheblicher Energiebedarf und Zeitaufwand erforderlich. Die Größe von zu beschichtenden Substratoberflächen ist wegen der entsprechenden Dimensionsbegrenzungen der Vakuumkammern eingeschränkt oder für große Substratoberflächen steigt der Energiebedarf für die Druckreduzierung weiter erheblich an. Mit den bekannten Vakuumbeschichtungstechniken sind außerdem begrenzte Abscheideraten verbunden, so dass bei ausreichenden Schichtdicken und großflächigen Substratoberflächen ein erhöhter Zeitaufwand in Kauf genommen werden muss.

Sollen Siliziumnitridschichten auf jeweiligen Substratoberflächen bei den in Rede stehenden Druckverhältnissen, also in der Nähe des jeweiligen Umgebungsatmosphärendruckes ausgebildet werden, wirken sich zwei Probleme nachteilig auf einen solchen Schichtausbildungsprozess aus.

Dabei werden Siliziumnitridschichten durch chemische Reaktionen ausgebildet und hierfür geeignete Siliziumverbindungen eingesetzt, die durch den Einfluss der Energie eines erzeugten Plasmas aufgespalten werden. Solche chemischen Verbindungen werden üblicherweise auch als Precursoren bezeichnet, die unmittelbar in die Plasmaquelle zugeführt oder später dem bereits mittels einer Plasmaquelle erzeugten Plasma zugegeben werden. Im letztgenannten Fall spricht man dann vom so genannten "Remote Plasma".

Am häufigsten wird Silan SiH₄ als Precursor für die Ausbildung reiner Silizium; wie auch für Siliziumnitrid-Schichten eingesetzt. Silan ist aber eine hochreaktive chemische Verbindung, deren Handhabung bei solchen Schichtbildungsprozessen erhebliche Sicherheitsvorkehrungen erfordert.

Aus DE 199 58 474 A1 ist in sehr allgemeiner Form auch auf den Einsatz von Tetramethylsilan, als ein geeigneter Precursor für die Ausbildung von Schichten auf Substratoberflächen mit einem Plasma hingewiesen worden.

Nowling G R et al: Remote plasma-enhanced chemical vapour deposition of silicon nitride at atmospheric pressure, Plasma Sources, Science and Technology, Feb. 2002, IOP Publishing, UK, Vol. 11, Nr. 1, S. 97 - 103 offenbart ein plasmachemisches Dampfabscheidungsverfahren zur Ausbildung dünner Schichten aus Siliziumnitrid auf Substratoberflächen.

Tetramethylsilan, nachfolgend als TMS bezeichnet, ist gegenüber Silan deutlich ungefährlicher und einfacher zu handhaben. Es besteht aber eine erhebliche Neigung zur Homogennukleation unter dem Einfluss des Plasma, so dass bei den bekannten Vorgehensweisen unter Einsatz von TMS, als Precursor Siliziumnitridschichten auf Substratoberflächen ausgebildet werden können, deren Oberflächen eine erhöhte Rauheit aufweisen, so dass die optischen und mechanischen Eigenschaften so hergestellter Siliziumnitridschichten für viele Anwendungsfälle unzureichend sind.

So können solche Schichten erst ab bestimmten Temperaturen physikalisch und chemisch dicht ausgebildet werden. Ihr optisches Verhalten bei Lichteinfall, insbesondere bezüglich der erreichbaren Reflexionseigenschaften ist unzulänglich, da ein großer Anteil von auftreffender elektromagnetischer Strahlung in relativ undefinierter Form an einer solchen Schichtoberfläche gestreut wird. Außerdem sind so hergestellte Siliziumnitridschichten mit einem erhöhten Reibungskoeffizienten behaftet. Des Weiteren neigen solche rauen Oberflächen zu einer Verschmutzung, die in vielen Anwendungsfällen unerwünscht ist.

Ein weiterer nachteiliger Aspekt bei der Ausbildung von Siliziumnitridschichten unter nahezu Atmosphärendruckbedingungen, besteht darin, dass in so hergestellten Siliziumnitridschichten ein erhöhter Anteil an Sauerstoff enthalten ist, der sich auf die bereits erwähnten optischen und mechanischen Eigenschaften genauso negativ auswirkt, wie auf das chemische bzw. elektrische Verhalten solcher auf den unterschiedlichsten Substraten ausgebildeten Schichten, wobei letztgenannter nachteiliger Aspekt insbesondere bei auf Solarzellen ausgebildeten transparenten Siliziumnitridschichten mit gleichzeitig passivierenden Eigenschaften nachteilig ist.

Es ist daher Aufgabe der Erfindung, Möglichkeiten vorzugeben, mit denen dünne transparente Siliziumnitridschichten auf Substratoberflächen unter Atmosphärenbedingungen ausgebildet werden können, bei denen verbesserte optische, mechanische Eigenschaften eine relativ hohe Reinheit des die Schicht bildenden Siliziumnitrides eingehalten und eine erhöhte Abscheiderate erzielt werden können.

Erfindungsgemäß wird diese Aufgabe mit einem Verfahren gemäß Anspruch 1, gelöst. Vorteilhafte Ausgestaltungsformen und Weiterbildungen der Erfindung können mit den in den untergeordneten Ansprüchen bezeichneten Merkmalen erreicht werden.

Bei der erfindungsgemäßen Lösung wird für die Ausbildung optisch transparenter dünner Schichten aus Siliziumnitrid, bei dem jeweiligen Atmosphärendruck in der unmittelbaren Umgebung entsprechenden Bedingungen, so verfahren, dass mit einer Plasmaquelle ein Plasma gebildet wird. Dabei wird zur Pläsmabildung ein Gasgemisch eingesetzt, dass aus einem atomaren und einem molekularen Gas, bevorzugt Argon und Stickstoff, besteht. Das gebildete Plasma wird auf eine jeweilige zu beschichtende Substratoberfläche gerichtet.

Für die Schichtausbildung wird eine Precursormischung eingesetzt, die neben einem elementorganischen Silan, bevorzugt einem Alkylsilan auch Ammoniak und/oder Stickstoff aufweist. Dabei sollen zumindest Ammoniak und/oder Stickstoff in das mittels der Plasmaquelle gebildete Plasma (Remote Plasma) eingeführt werden. Das jeweilige elementorganische Silan, beispielsweise Hexamethyldisilazan (HMDS) bzw. bevorzugt Tetramethylsilan (TMS) kann ebenfalls in dieses Remote Plasma zugeführt werden. Alternativ besteht aber auch die Möglichkeit, das elementorganische Silan zumindest teilweise dem Gasgemisch, das für die Plasmabildung eingesetzt wird, zuzugeben.

Insbesondere zur Vermeidung einer Homogennukleation wird Ammoniak der Precursormischung mit hohem Überschuss beigemischt. Dabei soll der Volumenstrom des zugeführten Ammoniaks mindestens 200-fach größer, als der Volumenstrom für das zugeführte Methylsilan, bevorzugt 350-fach größer und besonders bevorzugt 400-fach größer als der Volumenstrom des zugeführten Methylsilanes sein.

Infolge der Plasmaaktivierung kann das Methylsilan aufgespalten werden und es wird Siliziumnitrid durch chemische Reaktion auf der jeweilige Substratoberfläche in Form einer dünnen vorzugsweise optisch transparenten Schicht abgeschieden, wobei eine Schichtdicke im Bereich von 1 µm und auch darunter liegend erreichbar ist. Sollen Hartstoffschichten ausgebildet werden, können auch größere Schichtdicken erreicht werden.

Bei der Schichtbildung wird eine Relativbewegung einer Vorrichtung zur Durchführung des Verfahrens, mit der Plasma gebildet wird und der jeweiligen zu beschichtenden Substratoberfläche durchgeführt, so dass mit der erfindungsgemäß erreichbaren hohen Schichtbildungsgeschwindigkeit entsprechend große Substratoberflächen in kurzer Zeit beschichtet werden können.

Die Relativbewegung kann allein durch entsprechende Bewegung des jeweiligen Substrates in Bezug zur Vorrichtung, die auch Träger der Plasmaquelle ist, alleinige Bewegung dieser Vorrichtung sowie einer gleichzeitigen Bewegung von Substrat und Vorrichtung erfolgen. Im letztgenannten Fall kann die Bewegung in unterschiedlichen Richtungen von Substrat und Vorrichtung durchgeführt werden.

Bei der Erfindung sollten möglichst Plasmaquellen eingesetzt werden, mit denen ein relativ großvolumiges Plasma zur Verfügung gestellt werden kann, um entsprechend große Substratoberflächen abdecken zu können. Hierzu sind beispielsweise Mikrowellenplasmaquellen, aber auch besonders vorteilhaft Lichtbogenplasmaquellen geeignet. Bei Lichtbogenplasmaquellen sollten Kathode und Anode parallel zur jeweiligen Substratoberfläche ausgerichtet sein, so dass der zwischen ihnen brennende Lichtbogen ebenfalls entsprechend ausgerichtet ist und ein so lang gestrecktes Plasma gebildet werden kann, das eine Länge von mindestens 150 mm mit einer einzigen solchen Lichtbogenplasmaquelle erreicht werden kann.

Für die Plasmabildung sollte ein Gasgemisch eingesetzt werden, bei dem der Anteil an atomarem Gas deutlich größer, als der Anteil an molekularem Gas ist. So kann beispielsweise Argon mit mindestens doppelt so großem Volumenstrom, wie Stickstoff zur Plasmabildung zugeführt werden. Ein geeignetes Volumenstromverhältnis liegt bei beispielsweise 40 1/min Argon und 15 1/min Stickstoff.

Bei Einhaltung der bezeichneten Verfahrensparameter können die gewünschten optisch transparenten dünnen Siliziumnitridschichten auf den unterschiedlichsten Substratoberflächen ausgebildet werden. Dabei kann ein Reibungskoeffizient von 0,2 und eine Härte von mindestens 6 GPa bis hin zu 10 GPa, gemessen nach dem Universalhärteverfahren mit Berkovich Diamant und max. Last von 1 mN erreicht werden.

In den Siliziumnitridschichten kann ein Anteil von enthaltenem Sauerstoff, der ≤ 3% ist und ein Anteil von Kohlenstoff ≤ 5% eingehalten werden. Die Schichten können weiterhin unterschiedliche Gehalte an gebundenem Wasserstoff enthalten, der u.a. bestimmte elektrische und optische Eigenschaften der Schichten und des beschichteten Substrates günstig beeinflussen kann.

Zur Sicherung des relativ geringen Sauerstoffgehaltes ist es insbesondere vorteilhaft, den eigentlichen Schichtausbildungsbereich, der zwischen der jeweiligen Substratoberfläche und einer Vorrichtung angeordnet ist, gasdicht gegenüber der Umgebungsatmosphäre Luft abzudichten. Hierfür kann ein inertes Spülgas eingesetzt werden, um eine so genannte Gasdichtung bzw. Gasschleuse auszubilden. Das Spülgas soll dabei für die bei der Siliziumnitridschichtbildung ablaufenden chemischen Reaktionen inert sein.

Das inerte Spülgas sollte dabei zumindest in einen Spalt, der zwischen der Vorrichtung zur Plasmabildung und der Substratoberfläche zwangsläufig ausgebildet ist, einströmen, so dass ein Eindringen der Umgebungsatmosphäre durch den Spalt in den Schichtausbildungsbereich vermieden werden kann.

Hierzu sollte der Druck im Spalt, beispielsweise durch entsprechende Regelung des Druckes/Volumenstromes des eingesetzten Spülgases, so eingestellt werden, dass er gleich oder bevorzugt geringfügig größer bzw. kleiner als der Druck der Umgebungsatmosphäre ist.

Das so geführte Spülgas kann dann zu einem Teil durch den Spalt nach außen in die Umgebungsatmosphäre abströmen und ein weiterer Teil des Spülgases strömt dann in Richtung auf den Schichtausbildungsbereich. Um dadurch die Druckverhältnisse im Schichtausbildungsbereich nicht wesentlich negativ zu beeinflussen, sollte eine Abgasabsaugung vorhanden sein, mit der in diese Richtung strömendes Spülgas und auch beim Schichtbildungsprozess gebildete Abprodukte sowie überschüssige Precursorbestandteile, als Abgas abgesaugt werden können.

Hierzu sollte eine geeignete Regelung vorhanden sein, mit der die jeweiligen Drücke/Volumenströme von zugeführtem Spülgas und Abgas auch in Abhängigkeit der jeweiligen Prozessdrücke im Schichtausbildungsbereich sowie gegebenenfalls auch des jeweiligen Druckes der umgebenden Atmosphäre erfolgen können.

Bei einer Ausführungsform der erfindungsgemäßen Lösung, bei der im Durchlaufverfahren, also ein mit einer Siliziumnitridschicht zu versehendes Substrat durch eine Vorrichtung hindurchgeführt, gearbeitet wird, kann eine Zuführung für Spülgas in Form einer Schleuse ausgebildet sein, die am Einlauf und am Auslauf für das durch die Vorrichtung hindurch geführte Substrat angeordnet sind, so dass die gesamte Breite von schlitzförmigen Ein- und Ausläufen für Substrate mit dem Spülgasstrom gegenüber der umgebenden Atmosphäre auch bei bewegtem Substrat sicher abgedichtet werden kann.

In analoger Form kann auch in einem Abstand zu den jeweiligen Spülgaszuführungen eine Abgasabsaugung vorgesehen sein, wobei ein Teil einer Abgasabsaugung in Bewegungsrichtung des Substrates vor dem Schichtausbildungsbereich und ein zweiter Teil im Anschluss an den Schichtausbildungsbereich angeordnet sein kann. Der in Bewegungsrichtung des Substrates nach dem Schichtausbildungsbereich angeordnete Teil einer Abgasabsaugung sollte möglichst so dimensioniert sein, dass ein größerer Abgasvolumenstrom entfernt werden kann, als mit dem anderen Teil der Abgasabsaugung.

Eine solche im Durchlauf arbeitende Vorrichtung ist aber insbesondere für bestimmte Substratbreiten ausgelegt und eine endliche Breite wird dabei zum einen durch die jeweilige Länge von Schlitzen, die den Ein- und Auslauf bilden sowie die jeweilige Größe des erzeugbaren Plasmas begrenzt. Das gebildete Plasma hängt von der jeweiligen Plasmaquelle oder einer Anzahl mehrerer Plasmaquellen, die entsprechend angeordnet werden können, ab.

Eine höhere Flexibilität, was insbesondere die Ausbildung von Siliziumnitridschichten auf relativ großen zusammenhängenden Substratoberflächen oder bestimmten Bereichen von Substratoberflächen großer Substrate zutrifft, kann vorteilhaft mit einer Lösung gearbeitet werden, bei der größere Oberflächenbereiche von Substraten überstrichen werden können. Hierzu sollte eine vollständig um einen Schichtausbildungsbereich umlaufende Zuführung für Spülgas vorgesehen sein, mit der radial um den Schichtausbildungsbereich eine Abdichtung gegenüber der umgebenden Atmosphäre erreicht werden kann.

In diesem Fall ist es ebenfalls besonders vorteilhaft, eine Abgasabsaugung in analoger Form, also ebenfalls umlaufend um den Schichtausbildungsbereich auszubilden. Letzteres wirkt sich insbesondere dadurch vorteilhaft aus, dass über den Umfang des Schichtausbildungsbereiches nahezu konstante Druck- und auch Strömungsverhältnisse eingehalten werden können, so dass der Prozess der eigentlichen Schichtbildung mit zumindest annähernd konstanten Verhältnissen durchgeführt werden kann.

Für die Einhaltung günstiger Druck- und Strömungsverhältnisse, insbesondere im Spalt zwischen der Vorrichtung für die Plasmabildung und der jeweiligen mit einer Siliziumnitridschicht zu versehenden Substratoberfläche wirken sich die Einhaltung bestimmter Abstände vorteilhaft aus.

So sollte ein Abstand einer Zuführung für Spülgas in diesen Spalt zum radial äußeren Rand der Vorrichtung möglichst immer größer, bevorzugt mindestens doppelt so groß wie der Abstand der Zuführung für Spülgas zur ebenfalls umlaufend ausgebildeten Abgasabsaugung, eingehalten worden sein. Zusätzlich lässt sich durch eine solche Anordnung auch der Bedarf an zuzuführendem inerten Spülgas minimieren.

Die erfindungsgemäße Lösung zeichnet sich gegenüber dem Stand der Technik nicht nur durch die verbesserte Schichtqualität bezüglich sämtlicher Schichteigenschaften vorteilhaft aus, sondern das für die Schichtbildung zugeführte Alkylsilan, als Precursor ist relativ kostengünstig und im Vergleich zu Silan gefahrlos zu verarbeiten.

Beim Schichtbildungsprozess entstehen keinerlei für die Umwelt gefährlichen chemischen Verbindungen, wie beispielsweise Halogenide, bzw. es sind keine Restgasanteile von gefährlichen Stoffen, wie beispielsweise Silan in den Abgasen mehr enthalten, die eine gesonderte Nachbehandlung erfordern.

Bei der Schichtausbildung ist auch eine relativ geringe Erwärmung der jeweiligen Substratwerkstoffe zu verzeichnen, so dass eine Beschichtung bei einer großen Anzahl unterschiedlichster und teilweise auch temperaturempfindlicher Werkstoffe möglich ist. Wie bereits angesprochen, können auch relativ hohe Abscheideraten erreicht werden, so dass eine großflächige Beschichtung von Substratoberflächen in relativ kurzer Zeit möglich ist.

Nachfolgend soll die Erfindung beispielhaft näher erläutert werden.

Dabei zeigen:
- Figur 1: in schematischer Form eine perspektivische Darstellung einer Vorrichtung zur Ausbil- dung von dünnen, optisch transparenten Si- liziumnitridschichten im Durchlaufverfahren und
- Figuren 2 bis 4: in schematischer Form jeweils einen Teil- schnitt durch Vorrichtungen zur Ausbildung von Siliziumnitridschichten.

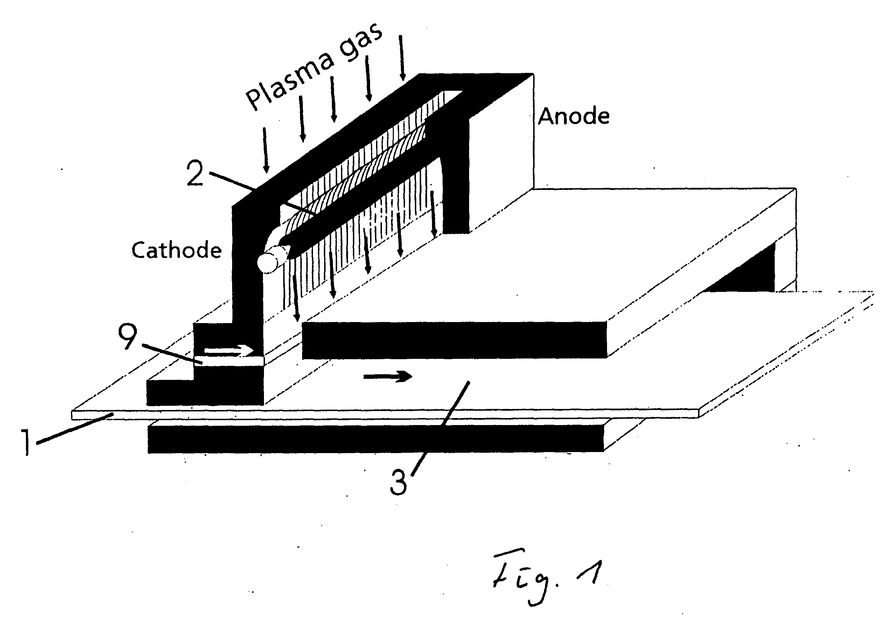

Mit der schematischen Darstellung nach Figur 1 soll die erfindungsgemäß mögliche Ausbildung von Siliziumnitridschichten auf flächigen Substraten verdeutlicht werden. Hierbei wird eine Lichtbogenplasmaquelle 2, bei der ein Lichtbogen zwischen einer Anode und einer Kathode brennt, eingesetzt. In den Lichtbogen wird ein Gasgemisch mit Stickstoff und Argon zur Plasmabildung zugeführt. Dabei wird Argon bevorzugt mit einem mindestens doppelt so großen Volumenstrom, wie Stickstoff zugeführt.

In das gebildete und in Richtung auf die jeweilige mit einer Siliziumnitridschicht zu versehende Substratoberfläche gerichtete Plasma wird über eine Zuführung 9 für.ein Precursorgasgemisch ein solches in das gebildete Plasma vor dem Auftreffen auf die jeweilige Substratoberfläche zugeführt. Das Precursorgasgemisch wird aus Ammoniak und bevorzugt TMS sowie molekularem Stickstoff gebildet. Der Anteil von Ammoniak und/oder Argon in Bezug zum TMS ist dabei sehr groß und die jeweiligen Volumenströme halten ein Verhältnis von 1:400 ein. Der Anteil von Stickstoff und/oder Argon in Bezug zum Ammoniak ist aber höher.

Das Remote Plasma, dem das Precursorgasgemisch zugeführt worden ist, durchströmt einen Schichtausbildungsbereich 3, der oberhalb der jeweiligen zu beschichtenden Substratoberfläche angeordnet ist.

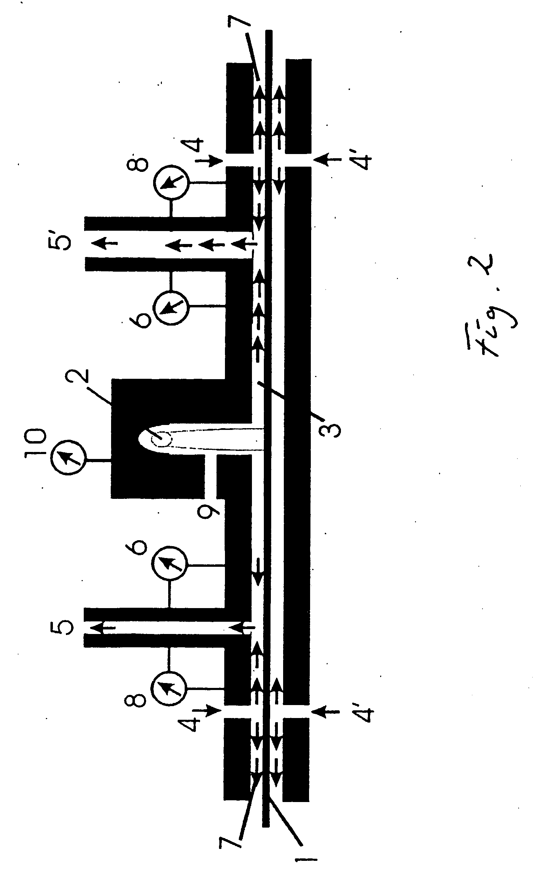

Wie insbesondere den Figuren 2 bis 4 entnommen werden kann, sollten für einen gasdichten Abschluss gegenüber der Umgebungsatmosphäre, mit dem insbesondere das Eindringen von Sauerstoff in den Schichtausbildungsbereich 3 verhindert werden kann, Zuführungen 4, 4' für ein inertes Spülgas vorgesehen sein.

Das Spülgas gelangt über die Zuführungen 4, in einen Spalt 7 zwischen einer Vorrichtung mit einer Plasmaquelle 2 und der jeweiligen Substratoberfläche. Das in den Spalt 7 einströmende Spülgas strömt im Spalt, wie mit den Pfeilen verdeutlicht, einmal nach außen und ein entsprechender Teil des Spülgases gelangt so in die Umgebungsatmosphäre. Ein weiterer Teilstrom des Spülgases strömt wiederum in Richtung des Schichtausbildungsbereiches 3, wird aber vor dessen Erreichen mit Hilfe der Abgasabsaugung 5, 5' entfernt.

Wie mit dem entgegengesetzt ausgerichteten Pfeil aus Richtung des Schichtausbildungsbereiches 3 angedeutet, gelangen aber auch Abgase aus dem Schichtausbildungsbereich 3 zur Absaugung 5, 5' und werden durch diese entfernt.

Mit den Sensoren 6 und 8 können die Drücke der Abgasabsaugung 5, 5' und der Spülgasdruck des zugeführten inerten Spülgases ermittelt und entweder mit den absolut gemessenen Drücken der Sensoren 6 und 8 bzw. mit entsprechenden Differenzdrücken, wie mit der Leitungsführung in Figur 2 verdeutlicht, die jeweiligen gemessenen Absolut- bzw. Differenzdrücke für die Regelung des abzuführenden Abgasvolumenstromes und des Druckes/Volu-menstromes für zugeführtes Spülgas geregelt werden.

Für die Regelung kann auch der mit dem Sensor 10 bestimmte Druck im Schichtausbildungsbereich 3 genutzt werden. Bei einer solchen Ausbildung und Regelung können eine unerwünschte Prozessbeeinträchtigung bei der Bildung von Siliziumnitridschichten und das Eindringen von Schadgasen aus der umgebenden Atmosphäre in den Schichtausbildungsbereich 3 vermieden werden.

In Figur 2 ist auch eine zweite Zuführung 4' für Spülgas von unten in Richtung auf die Unterseite des Substrates 1 gezeigt. Eine solche Ausführungsform ist insbesondere für Vorrichtungen, bei denen Substrate 1 im Durchlaufverfahren mit Siliziumnitrid beschichtet werden sollen, geeignet.

Bei anderen Ausführungsformen von Vorrichtungen, bei denen eine größere und flexiblere Beschichtung von großdimensionierten Substratoberflächen gewünscht ist, kann auf eine solche zusätzliche Zuführung 4' für Spülgas von unten verzichtet werden. Es ist aber dann erforderlich, eine Zuführung 4 für inertes Spülgas von oben auf die jeweilige zu beschichtende Substratoberfläche umlaufend um den Schichtausbildungsbereich 3 vorzusehen.

In Figuren 2 bis 4 wird außerdem deutlich, dass in distaler Richtung in Bezug zur Bewegungsrichtung des Substrates 1, an die Plasmaquelle 2 die Abgasabsaugung 5' größer dimensioniert ist, als die in proximaler Richtung angeordnete Abgasabsaugung 5. Die Abgasabsaugung 5' kann dementsprechend größere Volumenströme entfernen.

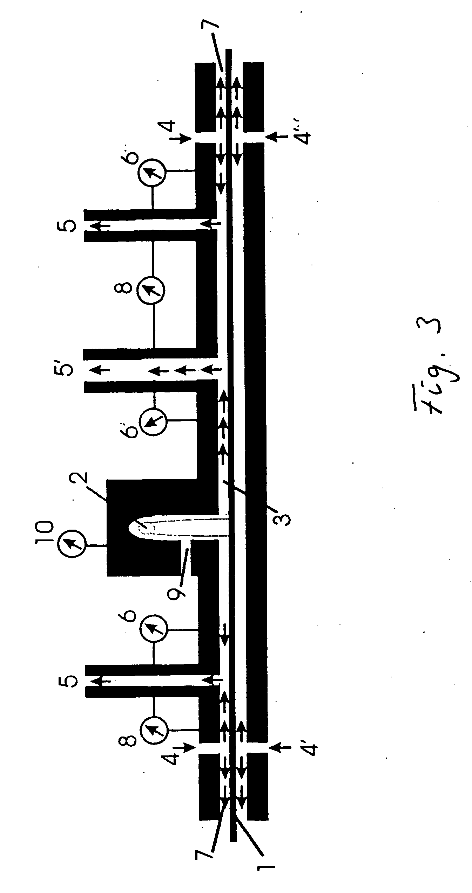

Das in Figur 3 gezeigte Beispiel unterscheidet sich vom Beispiel nach Figur 2 dadurch, dass in distaler Richtung, also im Anschluss an die Abgasabsaugung 5' eine weitere Abgasabsaugung 5 angeordnet ist.

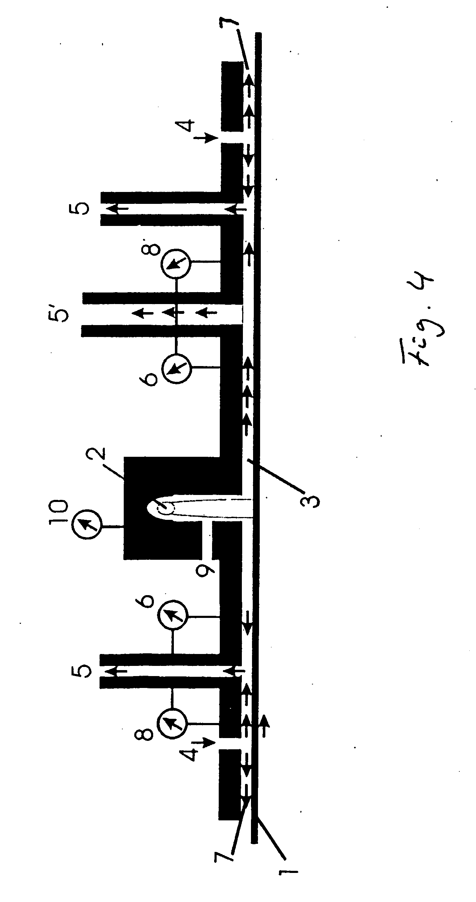

Dem in Figur 4 gezeigten Beispiel einer Vorrichtung zur Ausbildung von Siliziumnitridschichten im Wesentlichen auf das Beispiel nach Figur 3 zurückgegriffen. Dabei ist lediglich zusätzliche Spülgaszuführungen 4' der Unterseite des Substrates 1 verzichtet worden.

## Patentansprüche

1. Verfahren zur Ausbildung dünner Schichten aus Siliziumnitrid auf Substratoberflächen, bei dem Atmosphärendruck entsprechenden Bedingungen, bei dem
einer Plasmaquelle (2) zur Plasmabildung ein aus einem atomaren und einem molekularen Gas gebildeten Gasgemisch zugeführt,
in das gebildete und auf die jeweilige zu beschichtende Oberfläche strömende Plasma (Remote Plasma) eine aus Ammoniak und Stickstoff und/oder Argon gebildete oder enthaltende Precursormischung sowie
ein elementorganisches Silan, ebenfalls in das gebildete Plasma und/oder unmittelbar in die Plasmaquelle (2) als weiterer Precursor zugegeben werden;
wobei der Volumenstrom für zugeführtes Ammoniak mindestens 200-fach größer, als der Volumenstrom für zugeführtes elementorganisches Silan eingestellt wird; und
eine Relativbewegung einer Vorrichtung mit der das Plasma gebildet wird und der zu beschichtenden Substratoberfläche durchgeführt wird.

2. Verfahren nach Anspruch 1,
**dadurch gekennzeichnet, dass** ein Alkylsilan verwendet wird.

3. Verfahren nach Anspruch 1 oder 2,
**dadurch gekennzeichnet, dass** für die Plasmabildung Argon, als atomares Gas und Stickstoff, als molekulares Gas eingesetzt werden.

4. Verfahren nach Anspruch 1 oder 2,
**dadurch gekennzeichnet, dass** Argon mit einem mindestens doppelt so großen Volumenstrom, wie Stickstoff zur Plasmabildung der Plasmaquelle (2) zugeführt werden.

5. Verfahren nach einem der vorhergehenden Ansprüche, **dadurch gekennzeichnet, dass** als elementorganisches Silan Tetramethylsilan (TMS) oder Hexamethyldisilazan (HMS), als ein Precursor zugeführt wird.

6. Verfahren nach einem der vorhergehenden Ansprüche, **dadurch gekennzeichnet, dass** elementorganisches Silan und Ammoniak im Verhältnis von mindestens 1 zu 350 zugeführt werden.

7. Verfahren nach einem der vorhergehenden Ansprüche, **dadurch gekennzeichnet, dass** ein Schichtausbildungsbereich (3) gegenüber der Umgebungsatmosphäre mittels eines in einen Spalt (7) zwischen Vorrichtung zur Plasmabildung und Substratoberfläche einströmenden inerten Spülgas abgedichtet wird.

8. Verfahren nach einem der vorhergehenden Ansprüche, **dadurch gekennzeichnet, dass** mit dem inerten Spülgas im Spalt ein Druck eingestellt wird, der größer als der Druck der Umgebungsatmosphäre ist.

9. Verfahren nach einem der vorhergehenden Ansprüche, **dadurch gekennzeichnet, dass** gebildetes Abgas und Spülgas mittels einer Abgasabsaugung (5), die radial außen am Schichtausbildungsbereich angeordnet ist, abgeführt werden.

10. Verfahren nach einem der vorhergehenden Ansprüche, **dadurch gekennzeichnet, dass** Druck/Volumenstrom des in den Spalt strömenden inerten Spülgases und/oder der Abgasabsaugung (5, 5') in Abhängigkeit des Druckes im Schichtausbildungsbereich (3) geregelt wird/werden.

11. Verfahren nach einem der vorhergehenden Ansprüche, **dadurch gekennzeichnet, dass** eine Lichtbogen- oder Mikrowellenplasmaquelle (2) zur Plasmabildung eingesetzt wird.

## Claims

1. A method for forming thin layers of silicon nitride on substrate surfaces, under conditions corresponding to atmospheric pressure, in which
a gas mixture formed from an atomic and a molecular gas is supplied to a plasma source (2) for plasma formation,
to the plasma (remote plasma) which is formed and flows on to the respective surface to be coated there is added a precursor mixture formed of or containing ammonia and nitrogen and/or argon and
an organic silane is likewise added to the formed plasma and/or directly into the plasma source (2) as further precursor;
the volumetric flow rate for supplied ammonia being set at least 200 times greater than the volumetric flow rate for supplied organic silane; and
a relative movement of a device with which the plasma is formed and of the substrate surface to be coated is carried out.

2. A method according to Claim 1, **characterised in that** an alkylsilane is used.

3. A method according to Claim 1 or 2, **characterised in that** argon as atomic gas and nitrogen as molecular gas are used for the plasma formation.

4. A method according to Claim 1 or 2, **characterised in that** argon is supplied to the plasma source (2) at at least twice as large a volumetric flow rate as nitrogen for plasma formation.

5. A method according to one of the preceding claims, **characterised in that** as organic silane tetramethylsilane (TMS) or hexamethyldisilazane (HMS) is supplied as a precursor.

6. A method according to one of the preceding claims, **characterised in that** organic silane and ammonia are supplied in a ratio of at least 1 to 350.

7. A method according to one of the preceding claims, **characterised in that** a layer formation region (3) is sealed off from the surrounding atmosphere by means of an inert scavenging gas which flows into a gap (7) between the device for plasma formation and the substrate surface.

8. A method according to one of the preceding claims, **characterised in that** a pressure which is greater than the pressure of the surrounding atmosphere is set in the gap with the inert scavenging gas.

9. A method according to one of the preceding claims, **characterised in that** formed waste gas and scavenging gas are carried away by means of a waste-gas extraction means (5) which is arranged radially externally on the layer formation region.

10. A method according to one of the preceding claims, **characterised in that** the pressure/volumetric flow rate of the inert scavenging gas flowing into the gap and/or of the waste-gas extraction means (5, 5') is/are regulated dependent on the pressure in the layer formation region (3).

11. A method according to one of the preceding claims, **characterised in that** an arc or microwave plasma source (2) is used for the plasma formation.

## Revendications

1. Procédé de formation de couches minces de nitrure de silicium sur des surfaces de substrat dans des conditions correspondant à la pression atmosphérique, dans lequel
on achemine un mélange gazeux formé d'un gaz atomique et d'un gaz moléculaire à une source de plasma (2) pour former un plasma,
on ajoute au plasma formé et s'écoulant sur la surface respective à revêtir (remote plasma), un mélange précurseur formé d'ammoniac et d'azote et/ou d'argon ou en contenant, et on ajoute également au plasma formé et/ou directement à la source de plasma (2)
un silane organo-élémentaire, comme autre précurseur ;
le flux volumique de l'ammoniac acheminé étant réglé à une valeur au moins 200 fois supérieure à celle du débit volumique du silane organo-élémentaire acheminé ; et
un mouvement relatif étant effectué entre un dispositif avec lequel le plasma est formé et la surface de substrat à revêtir.

2. Procédé selon la revendication 1, **caractérisé en ce que** l'on utilise un alkylsilane.

3. Procédé selon la revendication 1 ou 2, **caractérisé en ce que**, pour former le plasma, on utilise de l'argon comme gaz atomique et de l'azote comme gaz moléculaire.

4. Procédé selon la revendication 1 ou 2, **caractérisé en ce que** pour la formation du plasma de l'argon est acheminé à la source de plasma (2) avec un débit volumique au moins deux fois supérieur à celui de l'azote.

5. Procédé selon l'une quelconque des revendications précédentes, **caractérisé en ce que** l'on achemine comme silane organo-élémentaire du tétraméthylsilane (TMS) ou de l'hexaméthyldisilazane (HMS) comme précurseur.

6. Procédé selon l'une quelconque des revendications précédentes, **caractérisé en ce que** du silane organo-élémentaire et de l'ammoniac sont acheminés dans un rapport d'au moins 1:350.

7. Procédé selon l'une quelconque des revendications précédentes, **caractérisé en ce qu'**une zone de formation de couche (3) est étanchée vis-à-vis de l'atmosphère ambiante au moyen d'un gaz de rinçage inerte pénétrant dans une fente (7) située entre le dispositif de formation de plasma et la surface de substrat.

8. Procédé selon l'une quelconque des revendications précédentes, **caractérisé en ce qu'**avec le gaz de rinçage inerte, on règle dans la fente une pression qui est supérieure à celle de l'atmosphère ambiante.

9. Procédé selon l'une quelconque des revendications précédentes, **caractérisé en ce que** le gaz d'échappement formé et le gaz de rinçage sont évacués au moyen d'un dispositif d'aspiration de gaz d'échappement (5), qui est agencé radialement à l'extérieur sur la zone de formation de la couche.

10. Procédé selon l'une quelconque des revendications précédentes, **caractérisé en ce que** la pression et/ou le débit volumique du gaz de rinçage inerte s'écoulant dans la fente et/ou du dispositif d'aspiration de gaz d'échappement (5, 5') est/sont réglé(s) en fonction de la pression dans la zone de formation de couche (3).

11. Procédé selon l'une quelconque des revendications précédentes, **caractérisé en ce que** l'on utilise une source de plasma à arc électrique ou à micro-ondes (2) pour former le plasma.
